(19) Europäisches Patentamt
European Patent Office
Office européen des brevets

(11) **EP 4 768 180 A1**

(12) **EUROPEAN PATENT APPLICATION**
published in accordance with Art. 153(4) EPC

(43) Date of publication:
01.07.2026 Bulletin 2026/27

(21) Application number: 24888391.0

(22) Date of filing: 12.09.2024

(51) International Patent Classification (IPC):
**B24B 49/12** *(2006.01)*      **B24B 5/18** *(2006.01)*
**H01L 21/304** *(2006.01)*

(52) Cooperative Patent Classification (CPC):
**B24B 5/18; B24B 49/12; H10P 52/00**

(86) International application number:
**PCT/JP2024/032775**

(87) International publication number:
**WO 2025/100091 (15.05.2025 Gazette 2025/20)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 10.11.2023 JP 2023192563

(71) Applicant: JFE Steel Corporation
Tokyo 100-0011 (JP)

(72) Inventors:
• WATANABE, Taku
Tokyo 100-0011 (JP)
• MAKITA, Haruyuki
Tokyo 100-0011 (JP)
• SUMIYA, Takuma
Tokyo 100-0011 (JP)

(74) Representative: Haseltine Lake Kempner LLP
Bürkleinstrasse 10
80538 München (DE)

(54) **GRINDING SYSTEM, GRINDING METHOD, AND METHOD FOR MANUFACTURING STEEL PRODUCT**

(57) A grinding system includes a shape measuring device configured to measure a three-dimensional shape and orientation of a material to be ground, a detection device configured to detect a position and shape of a grinding target portion that is present on a surface of the material to be ground, a grinding device (6) including a grinding tool, a movement mechanism configured to move the material to be ground relative to the shape measuring device and the grinding device, a grinding tool control unit (5) configured to generate a trajectory of the grinding tool for grinding the grinding target portion, and control the grinding device so that the grinding tool moves along the trajectory, and a movement mechanism control unit (12) configured to control the movement mechanism so that the material to be ground moves relative to the shape measuring device and the grinding device.

*FIG. 1*

EP 4 768 180 A1

**Description**

TECHNICAL FIELD

The present disclosure relates to a grinding system, a grinding method, and a method of producing a steel product. The present disclosure in particular relates to a grinding system, a grinding method, and a method of producing a steel product for removing defects present on the surface of a product such as a steel pipe or tube, a steel bar, or a round bar.

BACKGROUND

In the production of steel pipes or tubes or steel bars, defects (flaws) may occur on the outer surface of the product. Since defects occur at random positions on the outer surface of the product and the shapes of the products vary, defects have typically been removed manually by grinding with a grinder.

As a method of automatically removing defects, for example, PTL 1 discloses a defect grinding system that detects the position of a defect in a target material, generates a trajectory for a grinding tool to grind the defect, and moves the grinding tool along the trajectory to grind the defect.

CITATION LIST

Patent Literature

PTL 1: JP 7248148 B2

SUMMARY

(Technical Problem)

According to PTL 1, defects (flaws) present at various positions can be removed by grinding. Here, for example, when the target material is a long cylindrical product such as a steel pipe or tube, a steel bar, or a round bar, linear defects or the like may exist over a wide area. Furthermore, defects may exist beyond the movable range of the grinding device (for example, a range of approximately 180° that the grinding device faces). Demand exists for a method that can efficiently grind such defects without relying on human labor. Here, efficient grinding means grinding that is performed with fewer measurements or grinding passes per defect than with conventional techniques.

In view of the above circumstances, an aim of the present disclosure is to provide a grinding system, a grinding method, and a method of producing a steel product that enable efficient grinding.

(Solution to Problem)

    (1) A grinding system according to an embodiment of the present disclosure comprises:

        a shape measuring device configured to measure a three-dimensional shape and orientation of a material to be ground;
        a detection device configured to detect a position and shape of a grinding target portion that is present on a surface of the material to be ground;
        a grinding device comprising a grinding tool to grind the grinding target portion;
        a movement mechanism configured to move the material to be ground relative to the shape measuring device and the grinding device;
        a grinding tool control unit configured to generate a trajectory of the grinding tool for grinding the grinding target portion, based on the three-dimensional shape and orientation of the material to be ground measured by the shape measuring device and the position and shape of the grinding target portion detected by the detection device, and control the grinding device so that the grinding tool moves along the trajectory; and
        a movement mechanism control unit configured to control the movement mechanism so that the material to be ground moves relative to the shape measuring device and the grinding device when the shape measuring device measures the material to be ground and when the grinding target portion is ground by the grinding tool.

(2) As an embodiment of the present disclosure, in (1),

The material to be ground is a circular material having a circular cross-section in an axial direction.

(3) As an embodiment of the present disclosure, in (1) or (2),

the movement mechanism comprises

a rotation mechanism configured to move a circumferential position of the material to be ground relative to the shape measuring device and the grinding device, and

a slide mechanism configured to move an axial position of the material to be ground relative to the shape measuring device and the grinding device.

(4) As an embodiment of the present disclosure, in any one of (1) to (3),

the movement mechanism control unit relatively moves a circumferential position and an axial position of the material to be ground based on the position and shape of the grinding target portion.

(5) As an embodiment of the present disclosure, in any one of (1) to (4),

in a case in which a size of the grinding target portion is larger than a movable range of the grinding tool,

the grinding tool control unit is configured to generate a trajectory within the movable range and control the grinding device so that the grinding tool moves along the trajectory, and

the movement mechanism control unit is configured to determine relative movement amounts of a circumferential position and an axial position of the material to be ground based on the size of the grinding target portion and the movable range of the grinding tool.

(6) As an embodiment of the present disclosure, in any one of (1) to (5),

the movement mechanism control unit is configured to determine relative movement amounts of a circumferential position and an axial position of the material to be ground by prioritizing a large-size grinding target portion and excluding other grinding target portions that overlap with the large-size grinding target portion.

(7) A grinding method according to an embodiment of the present disclosure comprises:

a shape measuring process of measuring, by a shape measuring device, a three-dimensional shape and orientation of a material to be ground;

a detecting process of detecting a position and shape of a grinding target portion that is present on a surface of the material to be ground; and

a grinding process of generating a trajectory along which a grinding tool of a grinding device is to move, based on the measured three-dimensional shape and orientation of the material to be ground and the detected position and shape of the grinding target portion, and causing the grinding tool to move along the trajectory and grind the grinding target portion,

wherein in the shape measuring process and the grinding process, the material to be ground is moved relative to the shape measuring device and the grinding device.

(8) A method of producing a steel product according to an embodiment of the present disclosure comprises using the grinding method of (7) to grind a grinding target portion on a surface of a steel product, the steel product being the material to be ground.

(Advantageous Effect)

According to the present disclosure, a grinding system, a grinding method, and a method of producing a steel product that enable efficient grinding can be provided.

BRIEF DESCRIPTION OF THE DRAWINGS

In the accompanying drawings:

FIG. 1 is a diagram illustrating an overview of a grinding system according to an embodiment of the present disclosure;

FIG. 2 is a diagram illustrating an example of a defect in the present disclosure;

FIG. 3A is a diagram illustrating marking positions and grinding rotation positions;

FIG. 3B is a diagram illustrating a process flow of a grinding method;

FIG. 4A is a diagram illustrating cart position calculation;

FIG. 4B is a diagram illustrating cart position calculation;

FIG. 4C is a diagram illustrating cart position calculation;

FIG. 5 is a diagram illustrating a circumferential marking detection flow;

FIG. 6 is a diagram illustrating an overview of a circumferential development view;

FIG. 7A is a diagram illustrating a method of determining a cutout range of a circumferential development view;

FIG. 7B is a diagram illustrating a geometric model for calculating the angle of a material to be ground;

FIG. 8A is a diagram illustrating a cutout range on a two-dimensional image;

FIG. 8B is a diagram illustrating a created circumferential development view;

FIG. 9A is a diagram illustrating detection of markings;

FIG. 9B is another diagram illustrating the detection of markings;

FIG. 9C is another diagram illustrating the detection of markings;

FIG. 9D is another diagram illustrating the detection of markings;

FIG. 9E is another diagram illustrating the detection of markings;

FIG. 9F is another diagram illustrating the detection of markings;

FIG. 9G is another diagram illustrating the detection of markings;

FIG. 9H is another diagram illustrating the detection of markings;

FIG. 9I is another diagram illustrating the detection of markings;

FIG. 10 is a diagram illustrating a flow of rotation to a grinding rotation position i;

FIG. 11 is a diagram illustrating the flow from three-dimensional imaging to trajectory generation;

FIG. 12 is a diagram illustrating a flow of grinding operation execution at grinding rotation position i; and

FIG. 13 is a diagram illustrating the effect of reducing the number of workers.

## DETAILED DESCRIPTION

Hereinafter, a grinding system, a grinding method, and a method of producing a steel product according to an embodiment of the present disclosure will be described with reference to the drawings. In each drawing, identical or equivalent parts are marked with the same symbol. In the description of the present embodiment, a description of identical or equivalent parts will be omitted or simplified as appropriate.

Conventionally, to remove defects occurring over a wide area of a material to be ground, such as a circular material, a human operator performs grinding work while moving or rotating the material to be ground. Even in a system that automates defect removal, the work is considered by being dividing into the following elements. Analysis reveals that a grinding operation performed by an operator includes identifying the position of a defect in the longitudinal direction of the material to be ground (element 1), identifying the position of the defect in the circumferential direction of the material to be ground (element 2), and removing the defect by pressing a grinding tool against the defect position (element 3). A system and the like are described below while dividing the work into these elements as appropriate.

(Overall system configuration)

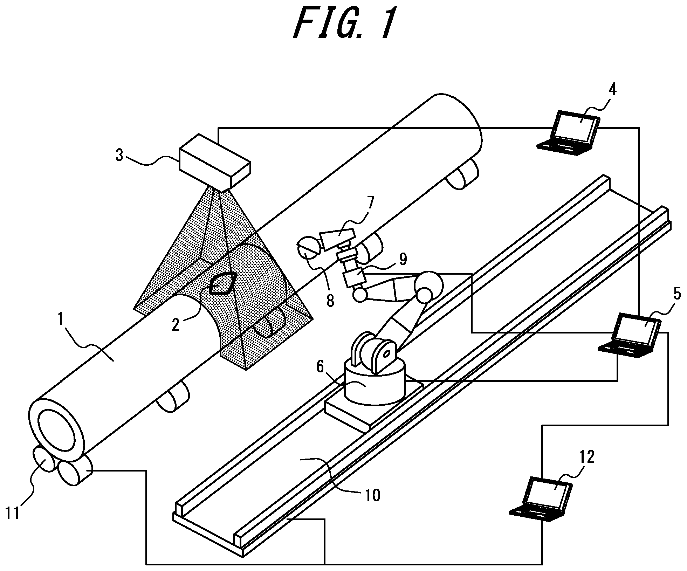

FIG. 1 illustrates an overview of a grinding system according to the present embodiment. The grinding system is a system for removing defects present on the surface of the material to be ground 1 and includes a shape measuring device, a detection device, a grinding device, a movement mechanism, a grinding tool control unit, and a movement mechanism control unit 12. The detection device, grinding tool control unit, and movement mechanism control unit 12 may, for example, be configured as one computer or a plurality of computers connected via a network.

In the present embodiment, the material to be ground 1 is, for example, a circular material having a circular cross-section in the axial direction, specifically a cylindrical elongated member such as a steel pipe or tube. The material to be ground 1 has a surface on which a grinding target portion 2 such as a defect to be ground is present.

In the present embodiment, a three-dimensional shape measuring device 3 (an example of a shape measuring device) measures the three-dimensional shape and orientation of the material to be ground 1. The three-dimensional shape measuring device 3 is a measuring device, generally called a 3D camera, that can simultaneously obtain two-dimensional image information and three-dimensional point cloud (solid) information.

In the present embodiment, an image processing device 4 (an example of a detection device) detects the position and shape of the grinding target portion 2 present on the surface of the material to be ground 1. The image processing device 4 detects the position and shape of the grinding target portion 2 by subjecting the captured image from the three-dimensional shape measuring device 3 to image processing. The image processing may be performed using a known method that uses a machine learning model such as deep learning.

Here, the grinding device is a device including a grinding tool for grinding the grinding target portion 2. The grinding tool control unit is a device that controls the grinding device. The grinding tool control unit generates a trajectory of the grinding tool for grinding the grinding target portion 2, based on the three-dimensional shape and orientation of the material to be ground 1 and the position and shape of the grinding target portion 2, and controls the grinding tool to move along the trajectory. In the present embodiment, a robot motion control unit 5 (an example of a grinding tool control unit) performs inverse kinematics calculations based on the position of the grinding target portion 2 detected by the image processing device 4. In the present embodiment, the motion trajectory of an articulated robot 6 (an example of a grinding device) that presses a grindstone 8 (an example of a grinding tool) provided on a grinder 7 against the position of the grinding target portion 2 is generated. The articulated robot 6 operates according to the generated motion trajectory, and the grindstone 8 comes into contact with the material to be ground 1 to grind the grinding target portion 2. At this time, a grinding reaction force measuring device 9 may measure the reaction force generated in the grinder 7. The robot motion control unit 5 may control the motion of the articulated robot 6 so as to press or release the grindstone 8 so that the measured reaction force becomes the target reaction force in grinding.

The grinding system according to the present embodiment includes a movement mechanism that moves the material to be ground 1 relative to the three-dimensional shape measuring device 3 and the articulated robot 6. The movement mechanism may include a rotation mechanism that rotates the material to be ground 1 relative to the three-dimensional shape measuring device 3 and the articulated robot 6 and a slide mechanism that moves the material to be ground 1 relative to the three-dimensional shape measuring device 3 and the articulated robot 6 in a direction different from the rotation direction. In the present embodiment, the grinding system has, as a movement mechanism, a movable cart 10 (an example of a slide mechanism) that moves the articulated robot 6 relative to the material to be ground 1 in the axial direction of the material to be ground 1. In addition, in the present embodiment, the grinding system has a turning roller 11 (an example of a rotation mechanism) as a movement mechanism, which rotates the material to be ground 1 in the circumferential direction of the material to be ground 1 relative to the three-dimensional shape measuring device 3 and the articulated robot 6. Here, the three-dimensional shape measuring device 3 can also be moved in the axial direction of the material to be ground 1 by a slide mechanism (not illustrated). In the present embodiment, the three-dimensional shape measuring device 3 moves in the axial direction of the material to be ground 1 in conjunction with the movable cart 10 (i.e., in conjunction with the articulated robot 6). In this way, the measurement range of the three-dimensional shape measuring device 3 and the movable range of the articulated robot 6 are linked.

In the example in FIG. 1, the articulated robot 6 is installed on a movable cart 10 that is movable in the axial direction of the material to be ground 1. The material to be ground 1 is placed on the turning roller 11 so as to be rotatable about its axis. The movable cart 10 and the turning roller 11 are controlled by the movement mechanism control unit 12. The movement mechanism control unit 12 can freely adjust the position of the articulated robot 6 in the axial direction (longitudinal direction) relative to the material to be ground 1 using the movable cart 10. In addition, the movement mechanism control unit 12 can freely adjust the angle (rotation angle) of the material to be ground 1 about its axis relative to the three-dimensional shape measuring device 3 and the articulated robot 6 by rotating the material to be ground 1 using the turning roller 11. The movement mechanism control unit 12 controls the movement mechanism so that the material to be ground 1 moves relative to the three-dimensional shape measuring device 3 and the articulated robot 6 when the material to be ground 1 is measured by the three-dimensional shape measuring device 3 and when the grinding target portion 2 is ground by the grindstone 8. The movement mechanism control unit 12 may relatively move the circumferential position and axial position of the material to be ground 1 based on the position and shape of the grinding target portion 2. Details will be described later, but when the size of the grinding target portion 2 is larger than the movable range of the grindstone 8, the movement mechanism control unit 12 may determine the relative movement amount of the circumferential position and axial position of the material to be ground 1 based on the size of the grinding target portion 2 and the movable range of the grindstone 8.

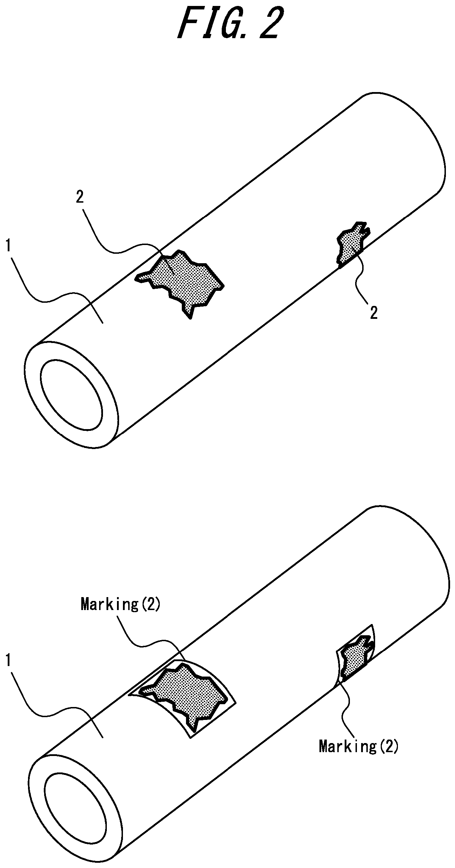

FIG. 2 is a diagram illustrating an example of a defect in the present disclosure. The grinding target portion 2 may be an actual defect present on the surface of the material to be ground 1 (see the upper portion of FIG. 2) or may be a marking applied so as to include a defect, as in the present embodiment. The type, shape, and dimensions of the grinding target portion 2 are not limited to specific cases. In the present embodiment, defects detected by non-destructive inspection (NDI) performed on a line separate from the grinding line are marked, and the material to be ground 1 is then sent to the grinding line. In the present embodiment, grinding is performed using the markings on the material to be ground 1 as the "grinding target portion 2".

(Grinding method)

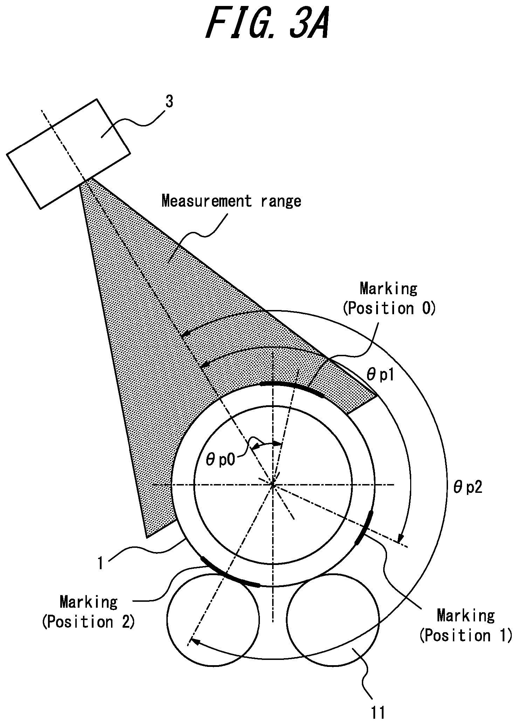

FIG. 3A illustrates an image of marking positions and grinding rotation positions for grinding by the turning roller 11. Using the logic described below, a grinding rotation angle $\theta_{pi}$ (i = 0 to N, and N is the number of grinding rotation positions, i.e., the number of markings) corresponding to each marking in the circumferential direction is calculated. By rotating the turning roller 11 by $\theta_{pi}$ from the initial position (i = 0), the marking is set to be in the optimal position (i.e., within the movable range of the articulated robot 6, which is the grinding device, and within the measurement range of the three-dimensional shape measuring device 3).

Here, in a method of producing a steel product, the grinding system can execute a method of grinding the grinding target portion 2 on the surface of the steel product, which is the material to be ground 1. The grinding method performed by the grinding system includes a shape measuring process, a detecting process, and a grinding process, and in the shape measuring process and the grinding process, the material to be ground 1 is moved relative to the shape measuring device and the grinding device. Here, the shape measuring process is a process of measuring, by a shape measuring device, the three-dimensional shape and orientation of the material to be ground 1. The detecting process is a process of detecting the position and shape of the grinding target portion 2 that is present on the surface of the material to be ground. Furthermore, the grinding process is a process of generating a trajectory along which the grinding tool of the grinding device is to move, based on the measured three-dimensional shape and orientation of the material to be ground 1 and the detected position and shape of the grinding target portion 2, and causing the grinding tool to move along the trajectory and grind the grinding target portion 2.

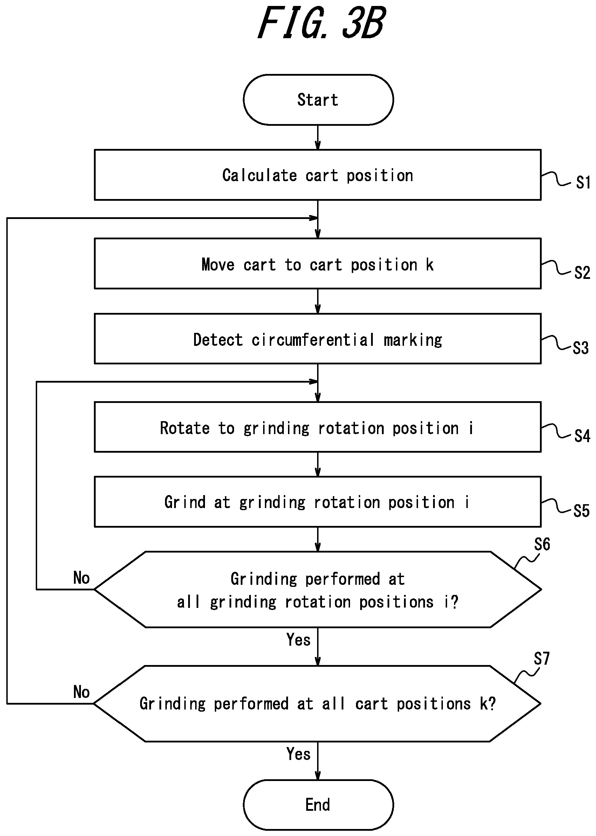

FIG. 3B illustrates an example of a specific process flow of such a grinding method. First, the positions of the markings in the axial direction of the material to be ground 1 is acquired. The positions of the markings may be obtained by, for example, measuring the surface of the material to be ground 1 with the three-dimensional shape measuring device 3, or by using an external sensor separate from the three-dimensional shape measuring device 3. By referring to the obtained longitudinal marking positions of the material to be ground 1, the number of cart positions M (the number of positions to which the movable cart 10 moves) and cart positions $L_{pk}$ (k = 0 to M) are calculated (step S1). The cart position $L_{p0}$ (k = 0) is the initial position.

The movable cart 10 moves to each of the calculated positions (step S2). That is, the grinding system moves the three-dimensional shape measuring device 3 and the articulated robot 6. Then, at that position, the three-dimensional shape measuring device 3 detects markings in the circumferential direction of the material to be ground 1 (step S3), and the number of grinding rotation positions N required and the grinding rotation angle $\theta_{pi}$ of each marking are calculated.

The turning roller 11 is rotated based on the calculated angle information so that the material to be ground 1 is placed at an appropriate grinding rotation position i (step S4). The material to be ground 1 is three-dimensionally measured by the three-dimensional shape measuring device 3, a machining trajectory is generated based on the shape, and grinding is performed (step S5). The grinding is repeated a number of times equal to the number of grinding rotation positions N (No in step S6), and when grinding is completed at all grinding rotation positions i (Yes in step S6), the cart moves to the next position (cart position). The cart moves a number of times equal to the number of cart positions M (No in step S7), and steps S2 to S6 are repeated. When grinding has been performed at all cart positions k (Yes in step S7), grinding of one material to be ground 1 is completed.

As described above, in the present embodiment, the material to be ground 1 is moved relative to the three-dimensional shape measuring device 3 and the articulated robot 6 in the shape measuring process and the grinding process. This means that even if a defect exists outside the measurement range of the three-dimensional shape measuring device 3 and outside the movable range of the articulated robot 6, the defect can be detected and ground by moving the material to be ground 1 relatively, making efficient grinding possible.

(Position calculation of the movable cart 10)

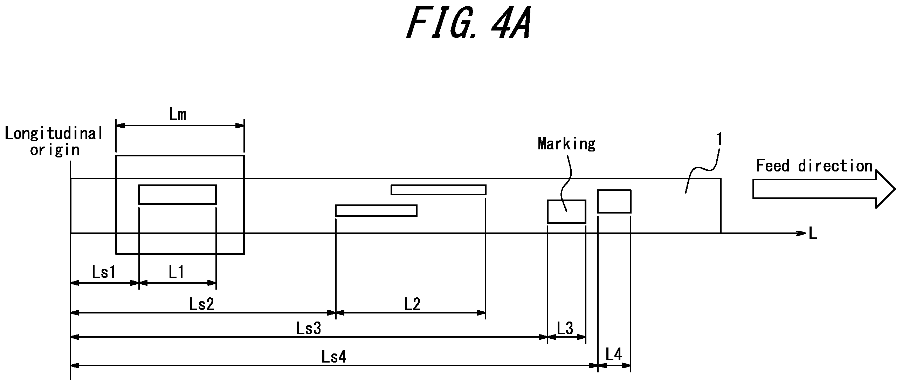

FIG. 4A is a diagram for explaining the cart position calculation and illustrates an image of marking positions and the imaging range. The distance from the longitudinal origin to the marking starting position is Lsk (k = 0 to M), and the size of the marking is Lk. Markings that overlap in the longitudinal direction (axial direction of the material to be ground 1) are considered to be one marking. Table 1 lists each marking and combinations of a plurality of markings. For markings larger than Lm, which is the range of one image capture by the three-dimensional shape measuring device 3, the long marking flag is set to "1", whereas for all other markings this flag is set to "0". The ending position Lek of the marking k is calculated using Expression (1).

$$Lek = Lk + Lsk \qquad \text{Expression (1)}$$

[Table 1]

Table 1

| Marking No. | Starting position | Marking length | Ending position | Long marking flag | Multiple marking flag |
|---|---|---|---|---|---|
| 1 | Ls1 | L1 | Le1 | 0 | 0 |
| 2 | Ls2 | L2 | Le2 | 1 | 0 |
| 3 | Ls3 | L3 | Le3 | 0 | 0 |
| 4 | Ls4 | L4 | Le4 | 0 | 0 |
| ... | | | | | |
| 1-2 | Ls1 | Le2 - Ls1 | Le2 | 1 | 1 |
| 1-3 | Ls1 | Le3 - Ls1 | Le3 | 1 | 1 |
| 1-4 | Ls1 | Le4 - Ls1 | Le4 | 1 | 1 |
| 2-3 | Ls2 | Le3 - Ls2 | Le3 | 1 | 1 |
| 2-4 | Ls2 | Le4 - Ls2 | Le4 | 1 | 1 |
| 3-4 | Ls3 | Le4 - Ls3 | Le4 | 0 | 1 |
| ... | | | | | |

Furthermore, the format and calculation formula illustrated in Table 2 are used for the notation and position of multiple markings (combinations of a plurality of markings). For example, a multiple marking with marking No. "1-2" means a combination of markings "1" and "2". Hereinafter, the marking position processing flow will be explained using this marking list as an example. The marking position processing flow corresponds to the detailed flow of step S1 in FIG. 3B.

[Table 2]

Table 2

| Marking No. | Starting position | Marking length | Ending position |
|---|---|---|---|
| n-m | Lsnm = Lsn | Lnm = Lem - Lsn | Lenm = Lem |

(Step 1)

As illustrated in Table 3, a column "one shot grinding range ranking" is added, in which markings whose long marking flag is "0" are ranked in descending order of length.

[Table 3]

Table 3

| Marking No. | Starting position | Marking length | Ending position | Long marking flag | Multiple marking flag | One shot grinding range ranking |
|---|---|---|---|---|---|---|
| 1 | Ls1 | L1 | Le1 | 0 | 0 | 2 |
| 2 | Ls2 | L2 | Le2 | 1 | 0 | - |
| 3 | Ls3 | L3 | Le3 | 0 | 0 | 3 |
| 4 | Ls4 | L4 | Le4 | 0 | 0 | 4 |
| ... | | | | | | |
| 1-2 | Ls12 | L12 | Le12 | 1 | 1 | - |
| 1-3 | Ls13 | L13 | Le13 | 1 | 1 | - |
| 1-4 | Ls14 | L14 | Le14 | 1 | 1 | - |
| 2-3 | Ls23 | L23 | Le23 | 1 | 1 | - |
| 2-4 | Ls24 | L24 | Le24 | 1 | 1 | - |
| 3-4 | Ls34 | L34 | Le34 | 0 | 1 | 1 |
| ... | | | | | | |

(Step 2)

As illustrated in Table 4, the cart position Lp1 is calculated for the marking with the highest "one shot grinding range ranking". When the highest ranked marking is marking k, the cart position Lp1 is calculated by Expression (2).

$$Lp1 = Lsk + Lk/2 \qquad \text{Expression (2)}$$

[Table 4]

Table 4

| Marking No. | Starting position | Marking length | Ending position | Long marking flag | Multiple marking flag | One shot grinding range ranking | Cart position |
|---|---|---|---|---|---|---|---|
| 1 | Ls1 | L1 | Le1 | 0 | 0 | 2 | |
| 2 | Ls2 | L2 | Le2 | 1 | 0 | - | |
| 3 | Ls3 | L3 | Le3 | 0 | 0 | 3 | |
| 4 | Ls4 | L4 | Le4 | 0 | 0 | 4 | |
| ... | | | | | | | |
| 1-2 | Ls12 | L12 | Le12 | 1 | 1 | - | |
| 1-3 | Ls13 | L13 | Le13 | 1 | 1 | - | |
| 1-4 | Ls14 | L14 | Le14 | 1 | 1 | - | |
| 2-3 | Ls23 | L23 | Le23 | 1 | 1 | - | |
| 2-4 | Ls24 | L24 | Le24 | 1 | 1 | - | |
| 3-4 | Ls34 | L34 | Le34 | 0 | 1 | 1 | Lp1 |

(continued)

| Marking No. | Starting position | Marking length | Ending position | Long marking flag | Multiple marking flag | One shot grinding range ranking | Cart position |
|---|---|---|---|---|---|---|---|
| ... | | | | | | | |

(Step 3)

As illustrated in Table 5, a process is performed to delete combinations or single markings included in the highest marking in the "one shot grinding range ranking". That is, a process is performed to delete large markings and overlapping markings.

[Table 5]

Table 5

| Marking No. | Starting position | Marking length | Ending position | Long marking flag | Multiple marking flag | One shot grinding range ranking | Cart position |
|---|---|---|---|---|---|---|---|
| 1 | Ls1 | L1 | Le1 | 0 | 0 | 2 | |
| 2 | Ls2 | L2 | Le2 | 1 | 0 | - | |
| ... | | | | | | | |
| 1-2 | Ls12 | L12 | Le12 | 1 | 1 | - | |
| 3-4 | Ls34 | L34 | Le34 | 0 | 1 | 1 | Lp1 |
| ... | | | | | | | |

(Step 4)

As illustrated in Table 6, the cart position Lp2 of the marking with the next highest "one shot grinding range ranking" is calculated using Expression (2). However, Lp1 in Expression (2) should be read as Lp2.

[Table 6]

Table 6

| Marking No. | Starting position | Marking length | Ending position | Long marking flag | Multiple marking flag | One shot grinding range ranking | Cart position |
|---|---|---|---|---|---|---|---|
| 1 | Ls1 | L1 | Le1 | 0 | 0 | 2 | Lp2 |
| 2 | Ls2 | L2 | Le2 | 1 | 0 | - | |
| ... | | | | | | | |
| 1-2 | Ls12 | L12 | Le12 | 1 | 1 | - | |
| 3-4 | Ls34 | L34 | Le34 | 0 | 1 | 1 | Lp1 |
| ... | | | | | | | |

(Step 5)

The above steps (Step 2 to Step 4) are repeated until there are no markings other than the long marking flag (all markings whose long marking flag is "0" are targeted). If there is no long marking flag, the process of calculating the positions of the movable cart 10 ends.

(Step 6)

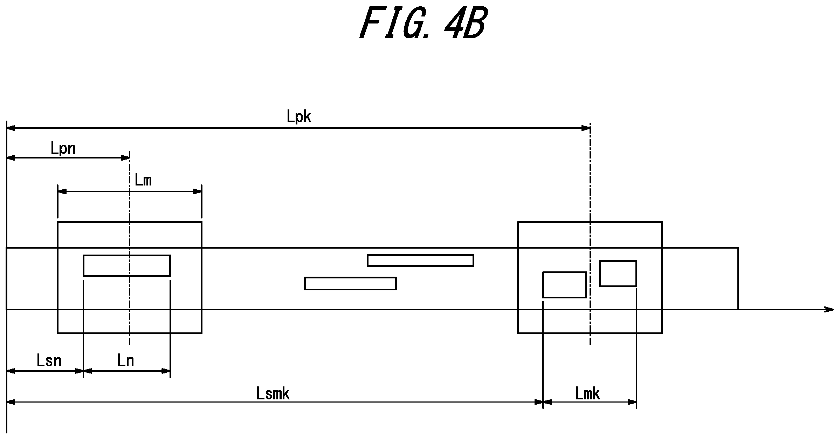

Here, as illustrated in FIG. 4B, the cart positions Lpk and Lpn are adjusted so that the center of the single marking or multiple marking is aligned with the center of the imaging range.

(Step 7)

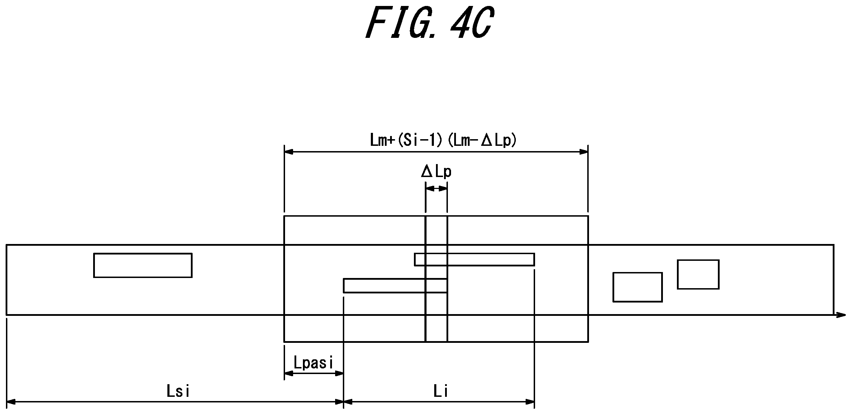

The remaining long markings are calculated as in Table 7. Furthermore, as illustrated in FIG. 4C, $\Delta$Lp may be set as an overlap allowance between the imaging range of the long marking and the grinding range. At this time, the number of grinding passes Sk of the long marking, a total grinding range Lpak, a grinding starting position Lpask, and each grinding position Lpkn (n = 1 to Sk) are calculated using Expressions (3) to (6). Here, Sk in Expression (3) is rounded up and provided as an integer.

$$Sk = (Li + \Delta Lp)/Lm \qquad \text{Expression (3)}$$

$$Lpak = Lm + (Sk - 1)(Lm - \Delta Lp) \qquad \text{Expression (4)}$$

$$Lpask = (Lpak - Li)/2 \qquad \text{Expression (5)}$$

$$Lpkn = Lsi - Lpask + n(Lm - \Delta Lp)/2 \qquad \text{Expression (6)}$$

[Table 7]

Table 7

| Marking No. | Starting position | Marking length | Ending position | Long marking flag | One shot grinding range ranking | Cart position |
|---|---|---|---|---|---|---|
| 1 | Ls1 | L1 | Le1 | 0 | 2 | Lp2 |
| 2 | Ls2 | L2 | Le2 | 1 | - | Lp31 to Lp32 |
| ... | | | | | | |
| 3-4 | Ls3 | Le4 - Ls3 | Le4 | 0 | 1 | Lp1 |
| ... | | | | | | |

(Step 8)

In Table 8, the cart positions Lpk for all individual markings or multiple markings are calculated.

[Table 8]

Table 8

| Marking No. | Starting position | Marking length | Ending position | Long marking flag | Multiple marking flag | One shot grinding range ranking | Cart position |
|---|---|---|---|---|---|---|---|
| 1 | Ls1 | L1 | Le1 | 0 | 0 | 2 | Lp2 |
| 2 | Ls2 | L2 | Le2 | 1 | 0 | - | Lp3 to Lp4 |
| ... | | | | | | | |
| 3-4 | Ls3 | Le4 - Ls3 | Le4 | 0 | 1 | 1 | Lp1 |
| ... | | | | | | | |

(Step 9)

In Table 9, the list is organized as a list of only the cart position Lp, the multiple marking flag, and the long marking flag and is then arranged in ascending order of Lpk.

[Table 9]

Table 9

| Cart position | Multiple marking flag | Long marking flag |
|---|---|---|
| Lp2 | 0 | 0 |
| Lp3 | 0 | 1 |
| Lp4 | 0 | 1 |
| Lp1 | 1 | 0 |

(Step 10)

As illustrated in Table 10, in the case of a plurality of long markings, a process may be performed to align the flag numbers of each long marking.

[Table 10]

Table 10

| Cart position | Multiple marking flag | Long marking flag |
|---|---|---|
| Lp2 | 0 | 0 |
| Lp3 | 0 | 1 |
| Lp4 | 0 | 1 |
| Lp1 | 1 | 0 |
| Lp7 | 0 | 3 |
| Lp8 | 0 | 3 |
| Lp9 | 0 | 3 |
| Lp5 | 0 | 2 |
| Lp6 | 0 | 2 |

Here, by executing the processing of step 3, the movement mechanism control unit 12 can determine the relative movement amount of the axial position of the material to be ground 1 by prioritizing a larger-sized grinding target portion 2 (marking) and excluding other grinding target portions 2 that overlap with the larger-sized grinding target portion 2. Similar processing is also performed for the circumferential position. Therefore, the grinding system according to the present embodiment enables efficient grinding.

(Method of detecting circumferential markings)

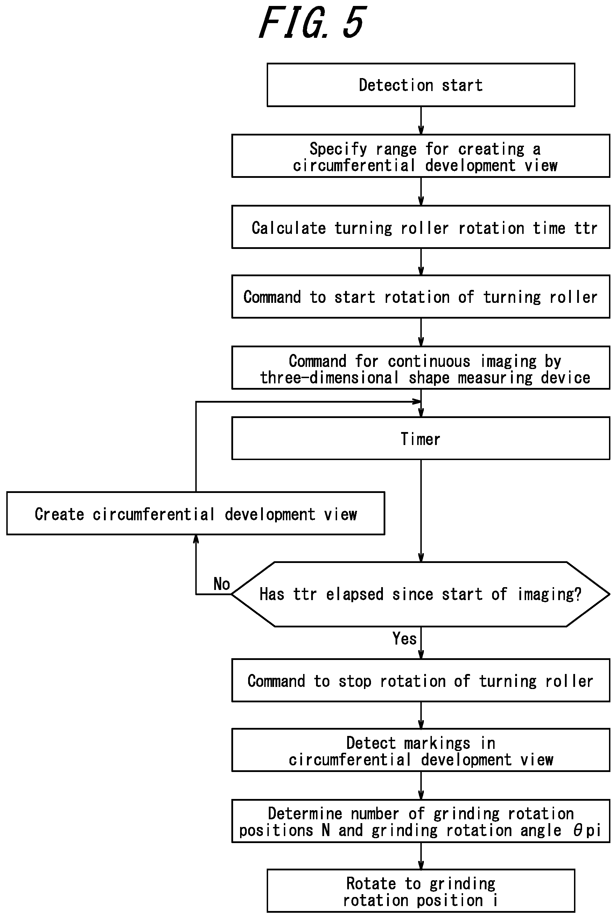

FIG. 5 illustrates the circumferential marking detection flow, that is, the detailed flow of step S3 in FIG. 3B. First, the range for creating the "circumferential development view" is specified. Next, a rotation time ttr of the turning roller 11 is calculated, and a turning roller rotation start command is output. At the same time, a continuous imaging command is issued to the three-dimensional shape measuring device 3, and the circumferential development view creation process is carried out until the rotation time ttr elapses on a timer. After ttr elapses, a command to stop the rotation of the turning roller is issued, the markings are detected from the created circumferential development view, the positions are calculated, and the number of grinding rotation positions N and the grinding rotation angles $\theta pi$ are determined. Subsequently, the turning roller 11 is rotated based on the determined angle information so that the material to be ground 1 is placed at an appropriate grinding rotation position i.

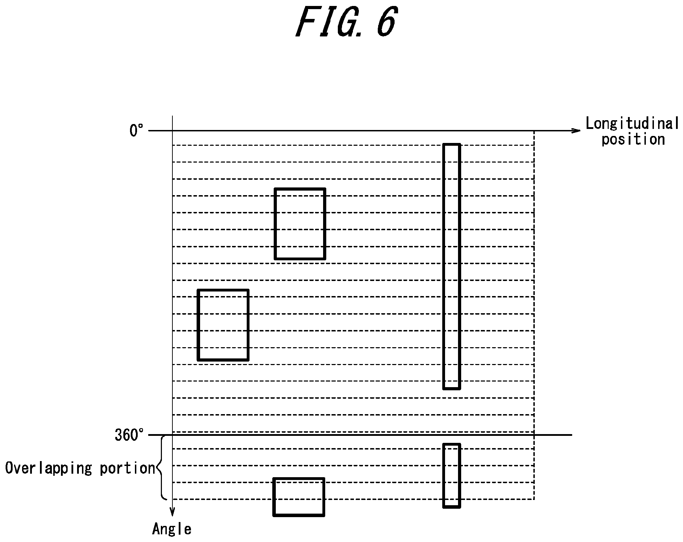

FIG. 6 is a diagram illustrating an overview of a circumferential development view. While the material to be ground 1 is being continuously rotated, the three-dimensional shape measuring device 3 captures two-dimensional images at regular intervals. As illustrated in FIG. 6, images are cut out from the captured images at specific locations where the material to be ground 1 appears, and the images are arranged in the order of capturing to create a circumferential development view. The circumferential development view is a drawing in which the longitudinal position of the material to be ground 1 is plotted on the horizontal axis and the angular position is plotted on the vertical axis. The position of the marking is calculated from the circumferential development view. The surplus in FIG. 6 is the overlapping portion obtained by rotating more than 360°.

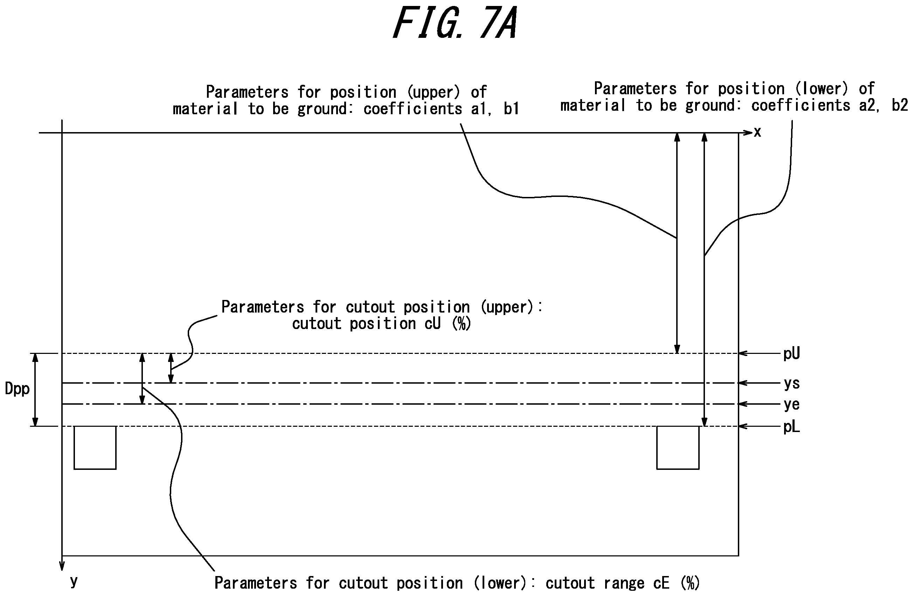

FIG. 7A is a diagram for explaining a method of determining a cutout range of a circumferential development view and illustrates the relationship between a captured two-dimensional image and parameters that determine which position on the image to cut out. A position (upper) pU of the material to be ground and a position (lower) pL of the material to be ground in the image that serve as the reference for the cutout position are calculated by Expressions (7) and (8).

$$pU = a1 \times Dp + b1 \qquad \text{Expression (7)}$$

$$pL = a2 \times Dp + b2 \qquad \text{Expression (8)}$$

Here, Dp is the diameter of the material to be ground. The material to be ground diameter Dpp in pixels is calculated from Expression (9).

$$[0064] \ Dpp = pU - pL \qquad \text{Expression (9)}$$

A cutout position (upper) ys and a cutout position (lower) ye on the image are calculated by Expressions (10) and (11).

$$ys = pU + Dpp \times cU \qquad \text{Expression (10)}$$

$$ye = pU + Dpp \times cE \qquad \text{Expression (11)}$$

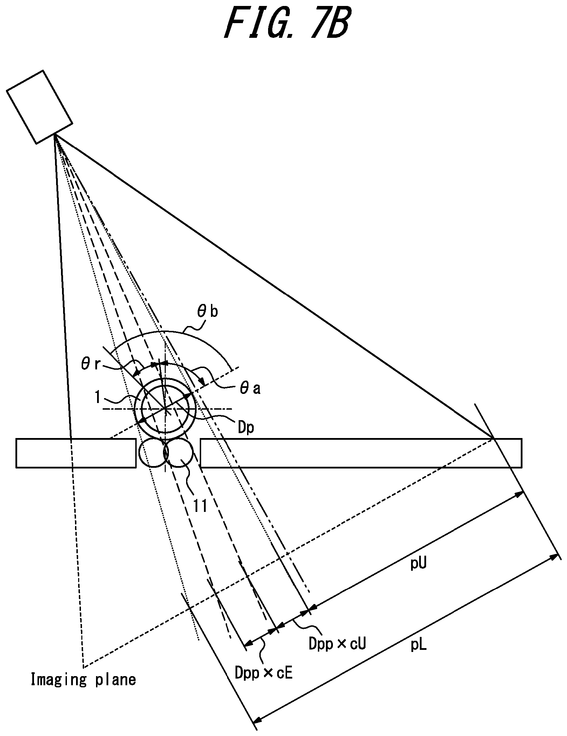

Here, a1, b1, a2, and b2 are arbitrary coefficients and can be determined by, for example, capturing images of the material to be ground 1 in a plurality of patterns with different diameters, plotting the upper and lower positions of each captured image, and determining the coefficients as a function of Dp using the least squares method. The parameters cU and cE are ratio parameters that take a value between 0 and 1 and determine the height position for cutting out the material to be ground 1 in the image. These parameters are set to satisfy the relationship cE > cU. FIG. 7B illustrates a geometric model for calculating the angle of the material to be ground 1. The angle and arc length of the area reflected on the surface of the material to be ground 1 are calculated using pU, pL, ys, and ye. The upper position in the image of the material to be ground 1 reflected in the image taken by the three-dimensional shape measuring device 3 is set to 0°, and an angle $\theta a$ to the cutout position (upper) ys and an angle $\theta b$ to the cutout position (lower) ye are calculated using Expressions (12) and (13).

$$\theta a = \cos^{-1}\{(50 - cU)/50\} \qquad \text{Expression (12)}$$

$$\theta b = \cos^{-1}\{(50 - cU - cE)/50\} \qquad \text{Expression (13)}$$

Furthermore, using the angles obtained by the above Expressions, a cutout angle range $\theta r$ and a cutout arc length $\Delta R$ are calculated from Expressions (14) and (15).

$$\theta r = a4 \times \theta b - a3 \times \theta a \qquad \text{Expression (14)}$$

$$\Delta R = Dp/2 \times \theta s \qquad \text{Expression (15)}$$

Here, a3 and a4 are parameters that can be set arbitrarily and are preferably set to 0 or more. The parameters a3 and a4 are preferably set to 2 or less. The parameters a3 and a4 compensate for the error between reality and the geometric model and are changed appropriately according to the values of cU, cE, and the like.

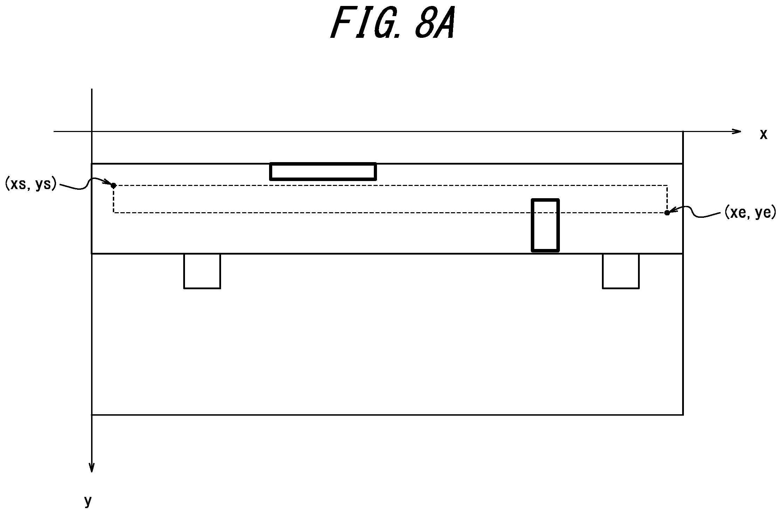

FIG. 8A illustrates the cutout area on a two-dimensional image. As illustrated in the drawing, when the vertical axis of the image is the y axis and the horizontal axis is the x axis, the cutout area is defined as a rectangle with two diagonal vertices, (xs, ys) and (xe, ye). The coordinates ys and ye are calculated by Expressions (10) and (11). The coordinates xs and xe are set based on the range that can be photographed by the three-dimensional shape measuring device 3 and the range in which the articulated robot 6 can operate. Here, when the x-direction positions of xs and xe in the three-dimensional space are xs3 and xe3, the aforementioned imaging range Lm is set according to Expression (16) for consistency.

$$Lm = xe3 - xs3 \qquad \text{Expression (16)}$$

Furthermore, when the rotational peripheral speed of the material to be ground 1 is V, a capturing interval tc and the rotation time ttr during imaging are calculated by Expressions (17) and (18).

$$tc = \Delta R/V(s) \qquad \text{Expression (17)}$$

$$ttr = tc(360 + \alpha)/\theta r \qquad \text{Expression (18)}$$

Here, $\alpha$ is a margin for creating a circumferential development view and is preferably set to a value of 360° or more.

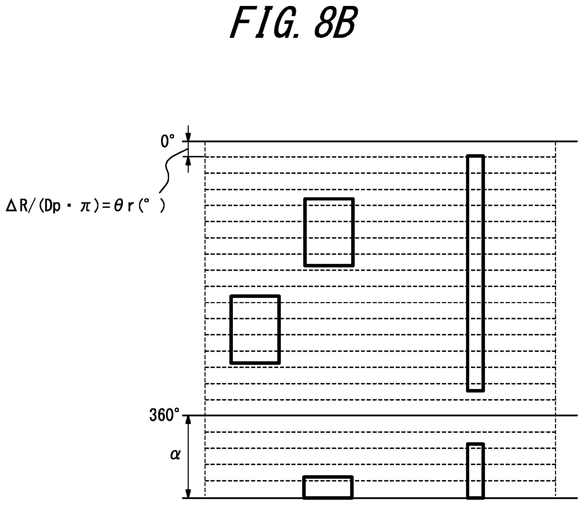

FIG. 8B illustrates a circumferential development view. As the material to be ground 1 rotates at a peripheral speed V, images are captured at intervals tc for a rotation time ttr, and the images cut out from the range defined by the aforementioned (xs, ys) and (xe, ye) are arranged in the order in which they were captured to create a circumferential development view.

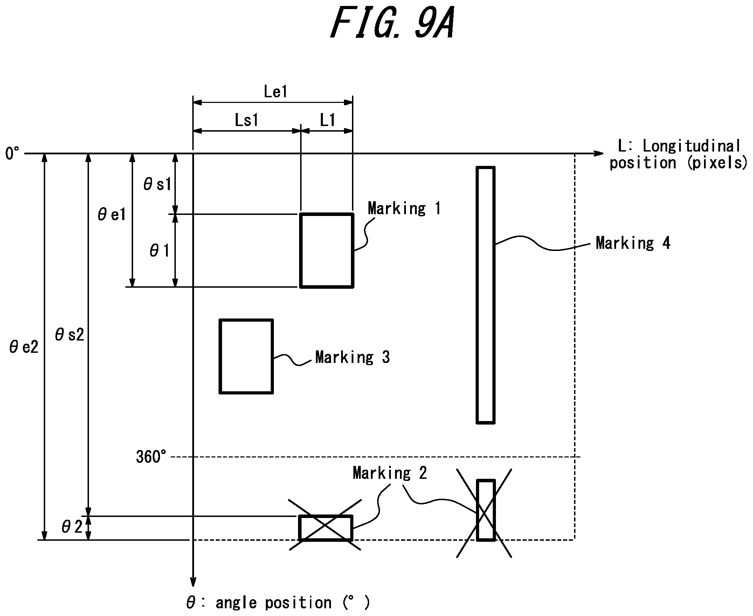

FIGS. 9A to 9I are diagrams illustrating the detection of markings in various patterns. First, FIG. 9A illustrates marking positions in a circumferential development view. In the present embodiment, the circumferential development view has the longitudinal position L set on the horizontal axis and the angular position set on the vertical axis, with the upper left corner referred to as the 0 point. The angular position of the marking existence starting position from the 0 point of the $i^{th}$ marking (illustrated as marking i) is $\theta si$, and the angular range of existence is $\theta i$. Furthermore, the longitudinal position from the 0 point to the marking existence starting position is Lsi, and the longitudinal range of existence is Li. Table 11 lists the markings existing in the circumferential development view. At this time, the marking for which $\theta si \geq 360°$ (marking 2 in FIG. 9A) is excluded from the list as a duplicate marking.

[Table 11]

Table 11

| Marking No. | Starting angle | Existence range angle | Ending angle | Starting position | Existence range position | Ending position |
|---|---|---|---|---|---|---|
| 1 | θs1 | θ1 | θe1 | Ls1 | L1 | Le1 |
| 3 | θs3 | θ3 | θe3 | Ls3 | L3 | Le3 |
| 4 | θs4 | θ4 | θe4 | Ls4 | L4 | Le4 |
| ... | | | | | | |

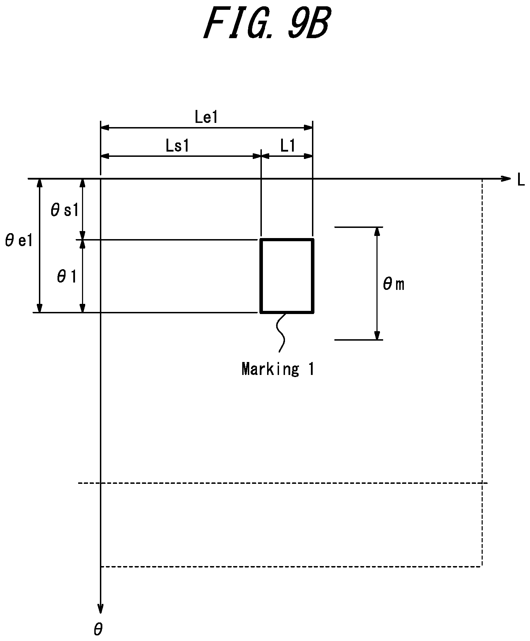

FIG. 9B illustrates an example of a circumferential development view in which a small marking exists alone. Here, θm in the drawing is the smaller value of either the angle range that can be imaged in one shot by the three-dimensional shape measuring device 3 or the movable range of the articulated robot 6. Here, a marking in the angle range θ > θm is considered to be a large marking, and the large marking flag is set to "1". For markings that are not large markings, the large marking flag is set to "0". Here, marking ending positions θei and Lei are calculated by Expressions (19) and (20). The grinding rotation angle θpi at the grinding rotation position i is calculated by Expression (21).

$$\theta ei = \theta si + \theta i \qquad \text{Expression (19)}$$

$$Lei = Lsi + Li \qquad \text{Expression (20)}$$

$$\theta pi = \theta si + \theta i/2 \qquad \text{Expression (21)}$$

Table 12 is a list of markings. This list includes the angular position, longitudinal position (axial position), and marking flag of each marking calculated by Expressions (19) to (21) and is created at each cart position of the movable cart 10. The example in Table 12 only has one row for the single marking, but in the below-described case of a plurality of markings, this table becomes a list with a plurality of rows.

[Table 12]

Table 12

| Marking No. | Starting angle | Existence range angle | Ending angle | Starting position | Existence range position | Ending position | Grinding rotation angle | Large marking flag |
|---|---|---|---|---|---|---|---|---|
| 1 | θs1 | θ1 | θe1 | Ls1 | L1 | Le1 | θp1 | 0 |
| ... | | | | | | | | |

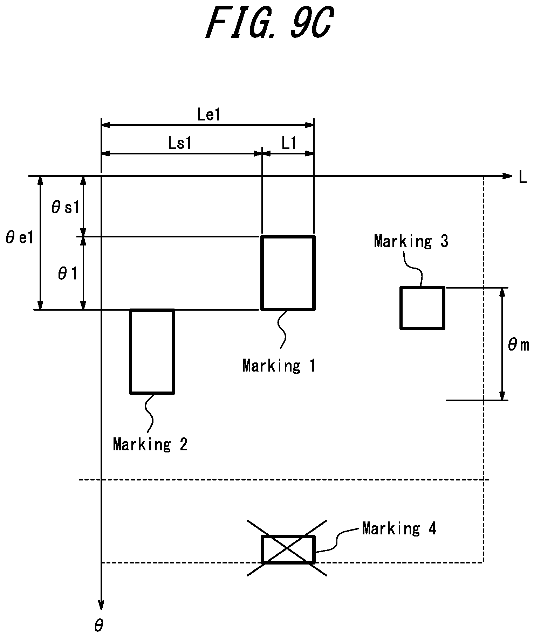

FIG. 9C illustrates an example with a plurality of small markings. Table 13 is a list of these markings. Table 14 also lists the definitions (how the values are determined) of the angles and positions of the plurality of markings. Table 15 is an organized list of a plurality of markings. The markings in the list are organized by the following steps.

[Table 13]

Table 13

| Marking No. | Starting angle | Existence range angle | Ending angle | Starting position | Existence range position | Ending position | Grinding rotation angle | Large marking flag |
|---|---|---|---|---|---|---|---|---|
| 1 | θs1 | θ1 | θe1 | Ls1 | L1 | Le1 | θp1 | 0 |

(continued)

| Marking No. | Starting angle | Existence range angle | Ending angle | Starting position | Existence range position | Ending position | Grinding rotation angle | Large marking flag |
|---|---|---|---|---|---|---|---|---|
| 2 | θs2 | θ2 | θe2 | Ls2 | L2 | Le2 | θp2 | 0 |
| 3 | θs3 | θ3 | θe3 | Ls3 | L3 | Le3 | θp3 | 0 |
| ... | | | | | | | | |
| 1-2 | θs12 | θ12 | θe12 | Ls12 | L12 | Le12 | θp12 | 1 |
| 1-3 | θs13 | θ13 | θe13 | Lsl3 | L13 | Le13 | θp13 | 0 |
| 2-3 | θs23 | θ23 | θe23 | Ls23 | L23 | Le23 | θp23 | 0 |
| ... | | | | | | | | |

[Table 14]

Table 14

| Starting condition | Ending condition | Starting angle | Existence range angle | Ending angle | Starting condition | Ending condition | Starting position | Existence range position | Ending position |
|---|---|---|---|---|---|---|---|---|---|
| θsi < θsj | θei < θej | θsi | θej to θsi | θej | Lsi < Lsj | Lei < Lej | Lsi | Lej to Lsi | Lej |
| θsi < θsj | θei > θej | θsi | θei to θsi | θei | Lsi < Lsj | Lei > Lej | Lsi | Lei to Lsi | Lei |
| θsi > θsj | θei < θej | θsj | θej to θsj | θej | Lsi > Lsj | Lei < Lej | Lsj | Lej to Lsj | Lej |
| θsi > θsj | θei > θej | θsj | θei to θsj | θei | Lsi > Lsj | Lei > Lej | Lsj | Lei to Lsj | Lei |

[Table 15]

Table 15

| Marking No. | Starting angle | Existence range angle | Ending angle | Starting position | Existence range position | Ending position | Grinding rotation angle | Large marking flag | Flag for grinding possibility at one position | Range ranking | Grinding ranking |
|---|---|---|---|---|---|---|---|---|---|---|---|
| 1 | $\theta s1$ | $\theta 1$ | $\theta e1$ | Ls1 | L1 | Le1 | $\theta p1$ | 0 | 1 | 4 | 1 |
| 2-3 | $\theta s23$ | $\theta 23$ | $\theta e23$ | Ls23 | L23 | Le23 | $\theta p23$ | 0 | 1 | 1 | 2 |
| ... | | | | | | | | | | | |

EP 4 768 180 A1

A flag (flag for grinding possibility at one position) is set for a marking that can be ground at one position, i.e., without rotating the material to be ground 1. If the large marking flag is "1", that is, if $\theta i > \theta m$, the flag for grinding possibility at one position becomes "0". Conversely, if $\theta i \leq \theta m$, the flag for grinding possibility at one position becomes "1".

Next, the markings whose flag for grinding possibility at one position is "1" are ranked according to the existence range angles. The marking with the largest existence range angle (largest size) is set to first place.

As in step 3 of the above-described cart position calculation, a process of deleting large markings and overlapping markings is performed. For the other markings, the process of selecting the marking with the largest existence range angle and deleting the overlapping markings is repeated until all flags for grinding possibility at one position become "1". Here, the order of grinding is set in ascending order of grinding angle (rotation angle) $\theta p$.

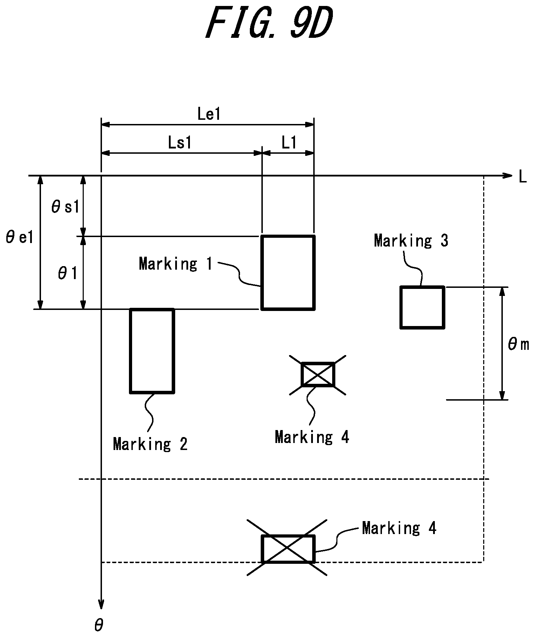

FIG. 9D illustrates an example in which a small marking is located among a plurality of small markings. Table 16 illustrates the marking list. In this case, a small marking (4) is located between a valid multiple marking (2-3). When the angular range of existence of a small marking is included in the angular range of existence of a large marking, the small marking can be ignored (deleted) because the markings can be ground together. This enables even more efficient grinding.

[Table 16]

Table 16

| Marking No. | Starting angle | Existence range angle | Ending angle | Starting position | Existence range position | Ending position | Grinding rotation angle | Large marking flag | Flag for grinding possibility at one position | Range ranking |
|---|---|---|---|---|---|---|---|---|---|---|
| 1 | θs1 | θ1 | θe1 | Ls1 | L1 | Le1 | θp1 | 0 | 1 | 6 |
| 4 | θs4 | θ4 | θe4 | Ls4 | L4 | Le4 | θp4 | 0 | 1 | 8 |
| ... | | | | | | | | | | |
| 2-3 | θs23 | θ23 | θe23 | Ls23 | L23 | Le23 | θp23 | 0 | 1 | 1 |
| ... | | | | | | | | | | |

EP 4 768 180 A1

18

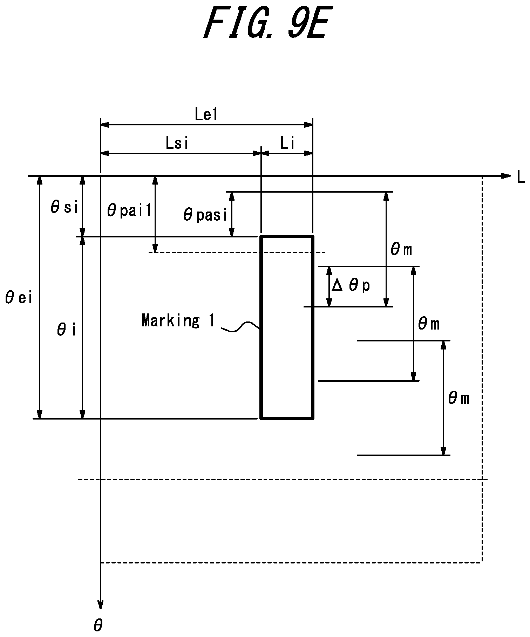

FIG. 9E illustrates the case of a large marking. For markings whose large marking flag is "1", a number of grinding passes Si, a total grinding range $\theta$pai, a grinding starting position $\theta$pasi, and each grinding rotation angle $\theta$pin (n = 1 to Si) of the large marking are calculated using Expressions (22) to (25). Here, it is assumed that $\Delta\theta$p is set as the overlap allowance of the large marking grinding range. Furthermore, Si in Expression (22) is rounded up and given as an integer.

$$Si = (\theta i + \Delta\theta p)/\theta m \qquad\qquad \text{Expression (22)}$$

$$\theta pai = \theta m + (Si - 1)(\theta m - \Delta\theta p) \qquad\qquad \text{Expression (23)}$$

$$\theta pasi = (\theta pai - \theta i)/2 \qquad\qquad \text{Expression (24)}$$

$$\theta pin = \theta si - \theta pasi + n(\theta m - \Delta\theta p)/2 \qquad\qquad \text{Expression (25)}$$

The large marking is ground separately from the other markings. As illustrated in the list of large markings in Table 17, each large marking has a plurality of grinding rotation angles $\theta$pin (n = 1 to Si) for one marking.

[Table 17]

Table 17

| Marking No. | Starting angle | Existence range angle | Ending angle | Starting position | Existence range position | Ending position | Grinding rotation angle | Large marking flag | Flag for grinding possibility at one position | Range ranking | Number of large grinding passes |
|---|---|---|---|---|---|---|---|---|---|---|---|
| 1 | θsi | θi | θei | Lsi | Li | Lei | θpi1 to θpiSi | 1 | 0 | 1 | Si |
| ... | | | | | | | | | | | |

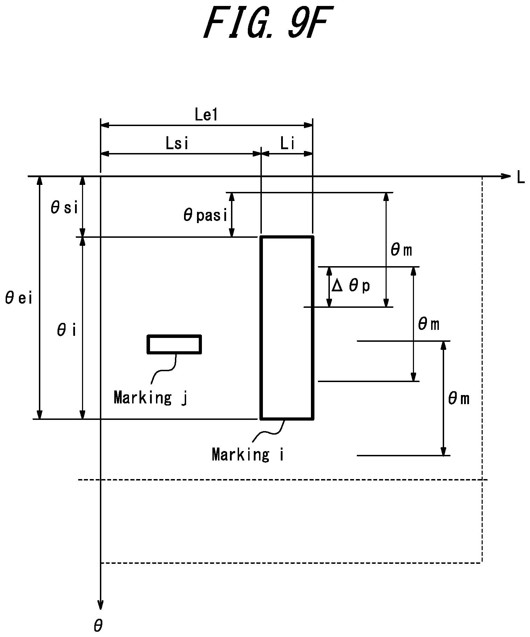

FIG. 9F illustrates a circumferential development view of a pattern with a large marking and a small marking. Table 18 illustrates the marking list. For the large marking, the grinding angles calculated by Expressions (22) to (25) are used regardless of the presence of other markings.

[Table 18]

Table 18

| Marking No. | Starting angle | Existence range angle | Ending angle | Starting position | Existence range position | Ending position | Grinding rotation angle | Large marking flag | Flag for grinding possibility at one position | Range ranking | Number of large grinding passes |
|---|---|---|---|---|---|---|---|---|---|---|---|
| i | θsi | θi | θei | Lsi | Li | Lei | θpi1 to θpiSi | 1 | 0 | 1 | Si |
| j | θsj | θj | θej | Lsj | Lj | Lej | θpj | 0 | 1 | 2 | - |
| ... | | | | | | | | | | | |

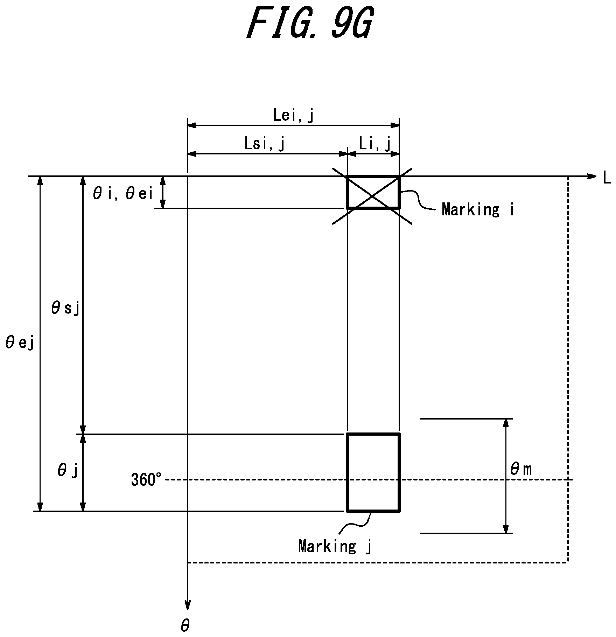

FIG. 9G illustrates a circumferential development view of a pattern with a marking for which $\theta si$ is 0. Such a marking for which "$\theta si = 0$" is a duplicated marking and is therefore ignored. Table 19 illustrates the marking list for this case.

[Table 19]

Table 19

| Marking No. | Starting angle | Existence range angle | Ending angle | Starting position | Existence range position | Ending position | Grinding rotation angle | Large marking flag | Flag for grinding possibility at one position | Range ranking | Number of large grinding passes |
|---|---|---|---|---|---|---|---|---|---|---|---|
| j | $\theta sj$ | $\theta j$ | $\theta ej$ | Lsj | Lj | Lej | $\theta pj$ | 0 | 1 | 2 | - |
| ... | | | | | | | | | | | |

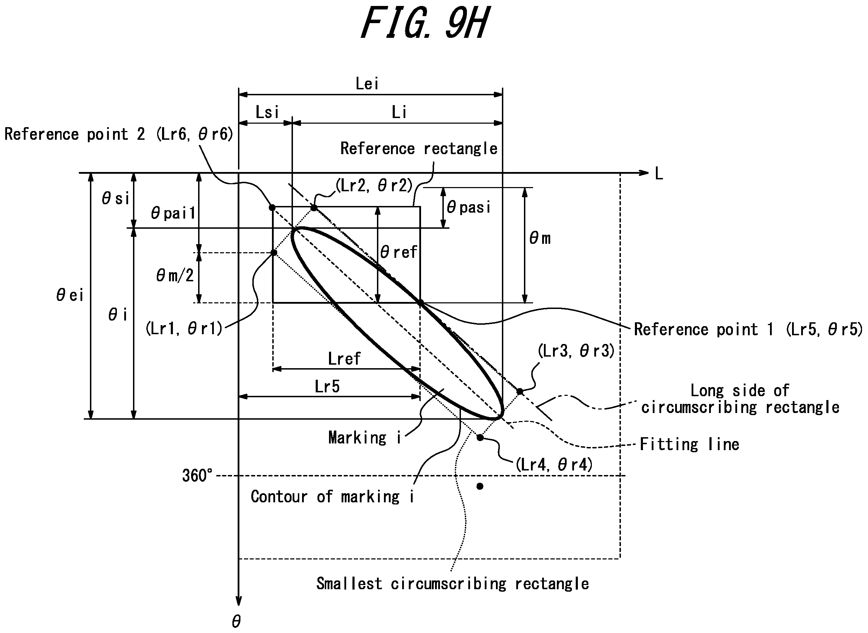

FIG. 9H illustrates a circumferential development view of the pattern of a diagonal marking. Table 20 illustrates the marking list.

[Table 20]

Table 20

| Marking No. | Starting angle | Existence range angle | Ending angle | Starting position | Existence range position | Ending position | Grinding rotation angle | Large marking flag | Flag for grinding possibility at one position | Range ranking | Number of large grinding passes | Diagonal marking flag |
|---|---|---|---|---|---|---|---|---|---|---|---|---|
| $i$ | $\theta si$ | $\theta i$ | $\theta ei$ | $Lsi$ | $Li$ | $Lei$ | $\theta pi1$ to $\theta piSi$ | 1 | 0 | - | $Si$ | 1 |
| ... | | | | | | | | | | | | |

The calculation for setting the grinding range for the diagonal marking is explained below. First, a contour length $Lci$ of the marking i determined to be a large marking is calculated.

If the condition of the following Expression (26) is satisfied, the diagonal marking flag is set to "1".

$$(Li + \theta i)/(Lci/2) > ac \qquad \text{Expression (26)}$$

Here, ac is a threshold for determining whether or not the marking is diagonal and is a parameter that can be set freely. Then, the smallest circumscribing rectangle of the diagonal marking is calculated, and the positions of the four corners of this rectangle $(Lr1, \theta r1)$, $(Lr2, \theta r2)$, $(Lr3, \theta r3)$, and $(Lr4, \theta r4)$ are calculated.

Furthermore, a straight line fitting of the circumscribing rectangle is performed. Reference points of the circumscribing rectangle are determined by the magnitude of the coefficient a of the fitting line function "$\theta = aL + b$". In the example of FIG. 9H, a is a value less than 0. When $\theta = aL + b1$ is to be determined for one (upper) long side of the circumscribing rectangle, b1 is calculated using Expression (27).

$$b1 = \theta r2/aLr2 \qquad \text{Expression (27)}$$

Calculations are performed on a reference rectangle that is assumed to be the grinding area. The coordinates $(Lr5, \theta r5)$ of a reference point 1 are calculated using Expressions (28) and (29), respectively.

$$Lr5 = (\theta r5 - b1)/a \qquad \text{Expression (28)}$$

$$\theta r5 = \theta pai + \theta m/2 \qquad \text{Expression (29)}$$

Furthermore, the coordinates $(Lr6, \theta r6)$ of a reference point 2 are calculated using Expressions (30) and (31), respectively.

$$Lr6 = Lr1 \qquad \text{Expression (30)}$$

$$\theta r6 = \theta r2 \qquad \text{Expression (31)}$$

An angle range $\theta ref$ and a length range $Lref$ of the reference rectangle are calculated by Expressions (32) and (33), respectively.

$$\theta ref = \theta si - \theta pasi + \theta m - \theta r2 \qquad \text{Expression (32)}$$

$$Lref = Lr5 - Lsi \qquad \text{Expression (33)}$$

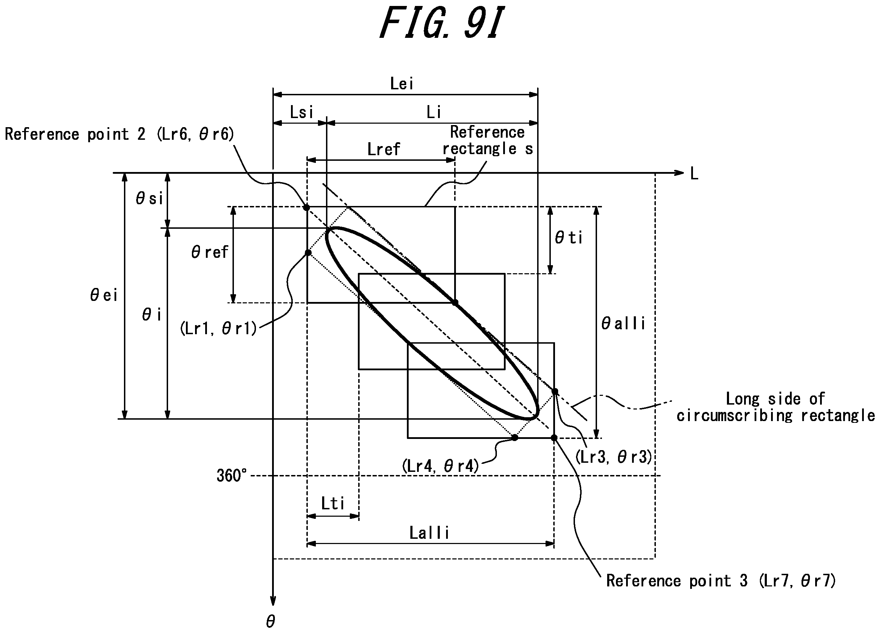

Another reference rectangle is set as illustrated in FIG. 9I. The coordinates $(Lr7, \theta r7)$ of a reference point 3 are calculated using Expressions (34) and (35), respectively.

$$Lr7 = Lr3 \qquad \text{Expression (34)}$$

$$\theta r6 = \theta r4 \qquad \text{Expression (35)}$$

A total grinding angle range $\theta alli$ and a total grinding longitudinal range $Lalli$ are calculated using Expressions (36) and (37), respectively.

$$\theta alli = \theta r4 - \theta r2 \qquad \text{Expression (36)}$$

$$Lalli = Lr3 - Lr1 \qquad \text{Expression (37)}$$

The number of grinding passes Si is calculated by Expression (38). Si in Expression (38) is rounded up and given as an integer.

$$Si = \theta all/\theta ref \qquad \text{Expression (38)}$$

A circumferential movement amount $\theta ti$ and an axial movement amount Lti are calculated using Expressions (39) and (40), respectively.

$$\theta ti = (\theta alli - \theta ref)/(Si - 1) \qquad \text{Expression (39)}$$

$$Lti = (Lalli - Lref)/(Si - 1) \qquad \text{Expression (40)}$$

An angle grinding overlapping margin $\Delta\theta ri$ and a position grinding overlapping margin $\Delta Lri$ are calculated using Expressions (41) and (42), respectively.

$$\Delta\theta ri = \theta si - \theta r2 \qquad \text{Expression (41)}$$

$$\Delta Lri = Lsi - Lr1 \qquad \text{Expression (42)}$$

The grinding rotation angle $\theta pin$ is calculated by Expression (43). Here, j is an integer ranging from 1 to Si.

$$\theta pin = \theta pai1 + (j - 1) \times \theta ti \qquad \text{Expression (43)}$$

In the above calculation, known available image processing functions or the like may be used. As illustrated in FIG. 9I, the grinding rotation angle $\theta pin$, the angle grinding overlapping margin $\Delta\theta ri$, the position grinding overlapping margin $\Delta Lri$, and the axial movement amount Lti are calculated so that the reference rectangles cover the diagonal marking in overlap. Table 21 is a marking list including these calculated values.

[Table 21]

Table 21

| Marking No. | Starting angle | Existence range angle | Ending angle | Starting position | Existence range position | Ending position | Grinding rotation angle | Large marking flag | Flag for grinding possibility at one position | Range ranking | Number of large grinding passes | Diagonal marking flag | Angle grinding overlapping margin | Position grinding overlapping margin | Axial movement amount |
|---|---|---|---|---|---|---|---|---|---|---|---|---|---|---|---|
| i | $\theta_{si}$ | $\theta_i$ | $\theta_{ei}$ | $L_{si}$ | $L_i$ | $L_{ei}$ | $\theta_{pi1}$ to $\theta_{piSi}$ | 1 | 0 | - | $S_i$ | 1 | $\Delta\theta_{ri}$ | $\Delta L_{ri}$ | $L_{ti}$ |
| ... | | | | | | | | | | | | | | | |

Table 22 is an example of the final marking list. According to this marking list, grinding is performed in the order of "diagonal markings", "large markings", "single markings", and "multiple markings". Within the same category, grinding is performed in ascending order of the grinding rotation angle $\theta pi$. The number of rows in the marking list is equal to the number of grinding rotation positions N. Furthermore, based on this list, mask processing for generating a grinding trajectory and cart position movement for large markings and diagonal markings (additional processing) may be performed.

[Table 22]

Table 22

| Marking No. | Grinding order (position) | Grinding rotation angle | Starting position | Existence range position | Large marking flag | Flag for grinding possibility at one position | Diagonal marking flag | Number of large grinding passes | Circumferential movement amount | Axial movement amount | Angle grinding overlapping margin | Position grinding overlapping margin |
|---|---|---|---|---|---|---|---|---|---|---|---|---|
| J | - | $\theta$p1 | Ls1 | L1 | 0 | 1 | 0 | | | | | |
| k | - | $\theta$p2 | Ls2 | L2 | 0 | 1 | 0 | | | | | |
| ... | | | | | | | | | | | | |
| I | - | $\theta$pi | Lsi | Li | 0 | 1 | 0 | | | | | |
| 2 | - | $\theta$pj1 to $\theta$pjSj | Lsj | Lj | 1 | 0 | 0 | Sj | | | | |
| 1 | - | $\theta$pk1 to $\theta$pkSk | Lsk | Lk | 1 | 0 | 1 | Sk | $\theta$tk | Ltk | $\Delta\theta$rk | $\Delta$Lrk |
| ... | | | | | | | | | | | | |

(Trajectory generation method)

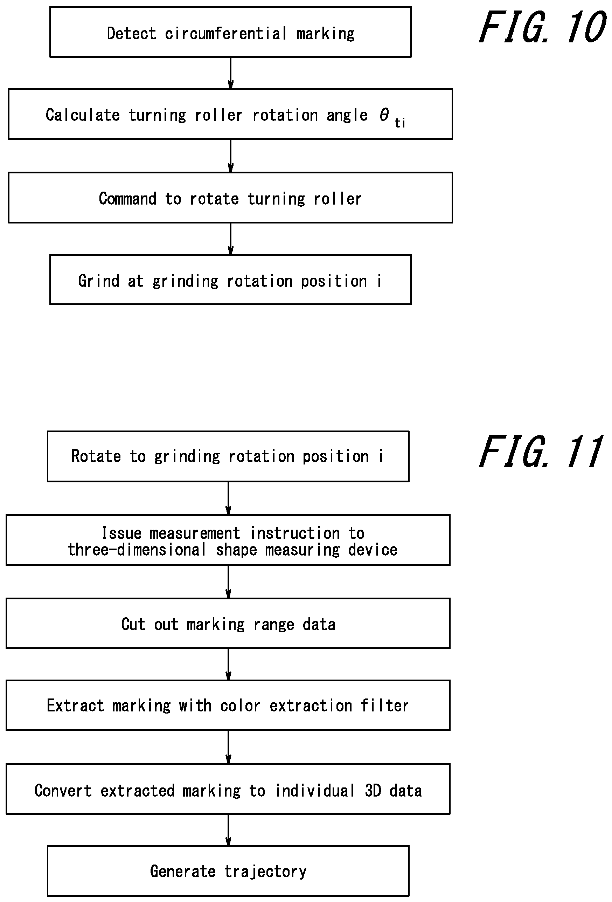

FIG. 10 illustrates the flow of rotation at grinding rotation position i and corresponds to the detailed flow of step S4 in FIG. 3B. The turning roller 11 rotates to rotate the material to be ground 1 to the grinding rotation angle θpi at the grinding rotation position i. A turning roller rotation angle θti and rotation time ttri at this time can be calculated using Expressions (44) and (45).

$$\theta ti = Dp/Dt \times (\theta pi - \theta p(i-1)) \qquad \text{Expression (44)}$$

$$ttri = \theta ti/V \qquad \text{Expression (45)}$$

Here, Dt is the turning roller diameter. Issuing a command to the turning roller 11 to rotate for the rotation time ttri enables rotation of the material to be ground 1 to a desired angle.

FIG. 11 illustrates the flow from three-dimensional imaging at the grinding rotation position i to trajectory generation and corresponds to the detailed flow of the processing up to immediately before grinding in step S5 of FIG. 3B. First, the three-dimensional shape measuring device 3 performs measurement. The measured data is in the form of two-dimensional images associated with three-dimensional point cloud (solid) information. First, the marking range of the grinding rotation position i is cut out from a two-dimensional image in the measured data. This is to prevent the generation of a trajectory that is mixed with other markings. Next, using a known color extraction filter (for example, an HSV color extraction filter), only the marking is extracted from the two-dimensional image. By applying a filter that sets a color within the range to "1" and a color outside the range to "0", the desired color alone can be extracted as a binary image. By further applying a median filter, Gaussian filter, contour area threshold filter, scaling filter, or the like to the binary image extracted here, a noise-free binary image containing only the marking can be obtained. By cutting out only the portion where the marking is present, three-dimensional point cloud data of only the marking can be obtained. Through this series of processes, it is possible to obtain two-dimensional and three-dimensional data of only the marking. The trajectory is generated based on this three-dimensional data.

Here, a mask may also be set. For example, the positions pU and pL of the material to be ground 1 on the image are determined by the above Expressions, but masks may be set so as to cut only an area over a narrower vertical interval. For example, a mask may be set from the upper position pU of the material to be ground 1 on the image down to a position ymU. Also, for example, a mask may be set from the lower position pL of the material to be ground 1 on the image up to a position ymL. The positions of ymU and ymL on the image may be calculated using Expressions (46) and (47).

$$ymU = pU + Dpp \times (cmU + Dpp \times amU) \qquad \text{Expression (46)}$$

$$ymL = pL - Dpp \times (cmL + Dpp \times amL) \qquad \text{Expression (47)}$$

Here, cmU, cmL, amU, and amL are parameters that can be set freely. The parameters cmU and cmL set the ratio of the mask range to the diameter Dpp of the material to be ground 1 on the image. Furthermore, amU and amL are parameters for correcting the mask range according to the diameter and are preferably set to 0 or more. The parameters amU and amL are preferably set to 1 or less.

The trajectory is generated by setting grinding parameters and arranging "machining control points (control points)" according to the obtained three-dimensional data of only the markings. The grinding parameters are a group of parameters used to set a portion of the three-dimensional point cloud of the marking and the distance from which control points are placed from that portion, the spacing between control points, the spacing between single "passes" of grinding, the angle and distance for contact or separation, and the like. Each of the set control points is transmitted to the articulated robot 6 as trajectory data.

(Method of controlling grinding tool)

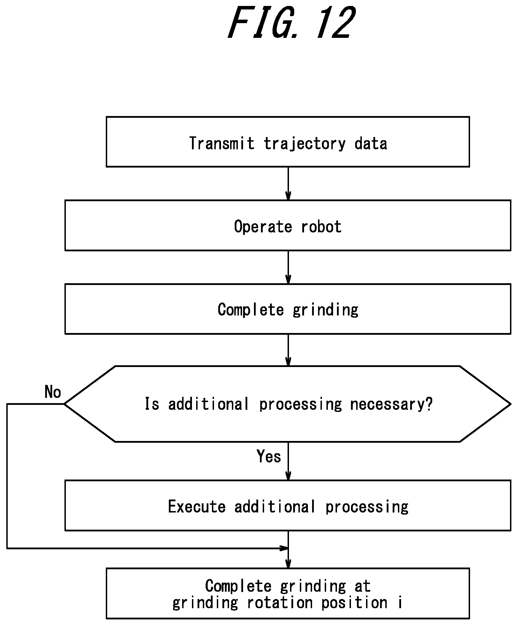

FIG. 12 illustrates the flow of grinding operation execution at grinding rotation position i and corresponds to the detailed flow of grinding in step S5 of FIG. 3B. When the trajectory data is transmitted, the articulated robot 6 starts to operate. After the articulated robot 6 operates and one grinding operation is completed, additional processing is required in the case of a large marking or diagonal marking. In the case of other markings, grinding at grinding rotation position i is completed.

Additional processing is performed when grinding a large marking. Based on the marking information list, the rotation angle θti of the turning roller 11 is determined by Expression (48). Here, j in the Expression satisfies 1 < j < Si and indicates that the j$^{th}$ rotation position in the marking corresponds to the grinding rotation position i.

$$\theta ti = Dp/Dt \times (\theta pij - \theta pi(j-1)) \qquad \text{Expression (48)}$$

After the turning roller 11 is rotated by the angle θti, the trajectory data that has already been created is transmitted to the articulated robot 6, and the articulated robot 6 performs the grinding operation. Thereafter, repetition of "rotation of the turning roller 11 and grinding" for the set number of grinding passes Si enables grinding of the large marking while making use of the initially created trajectory. That is, in the case of a large marking (when the size of the grinding target portion 2 is larger than the movable range of the grindstone 8), a trajectory is generated within the movable range of the grindstone 8 (within the measurement range of the three-dimensional shape measuring device 3) at the position of angle θpi1 of the material to be ground 1. The articulated robot 6 is then controlled so that the grindstone 8 moves along the generated trajectory, and grinding is performed. Subsequently, the material to be ground 1 is rotated to an angle θpi2, and grinding is performed along the same trajectory as the trajectory created at the position of angle θpi1. Grinding and rotation are repeated in this manner until the material to be ground 1 is rotated to an angle θpiSi.

When generating a trajectory, it takes time to perform three-dimensional imaging, color extraction processing, and calculations for generating the trajectory. Therefore, by making use of the trajectory data that has already been created, it is possible to grind the large marking efficiently. Here, after grinding Si times, the rotation of the turning roller 11 needs to be returned to the position where the original trajectory was generated. The rotation angle θre in this case is determined by Expression (49).

$$\theta re = -Dp/Dt \times (Si - 1)\theta ti \qquad \text{Expression (49)}$$

The turning roller 11 is rotated by θre to complete grinding at the grinding rotation position i.

Additional processing is performed when grinding the diagonal marking. The rotation angle θti of the turning roller 11 based on the marking information list is calculated by Expression (48) in the same way as for the large marking.

The turning roller 11 is rotated by the angle θti, after which the position of the movable cart 10 is moved by Lti, the trajectory data that has already been created is transmitted to the articulated robot 6, and the articulated robot 6 performs the grinding operation. Repetition of "rotation of the turning roller 11, movement of the cart, and grinding" for the set number of grinding passes Si enables grinding of the large marking while making use of the initially created trajectory. After grinding Si times, the turning roller 11 is rotated by θre to complete grinding at the grinding rotation position i. The rotation angle θre is calculated by Expression (49) in the same way as for the large marking.

(Effect of reduced number of workers)

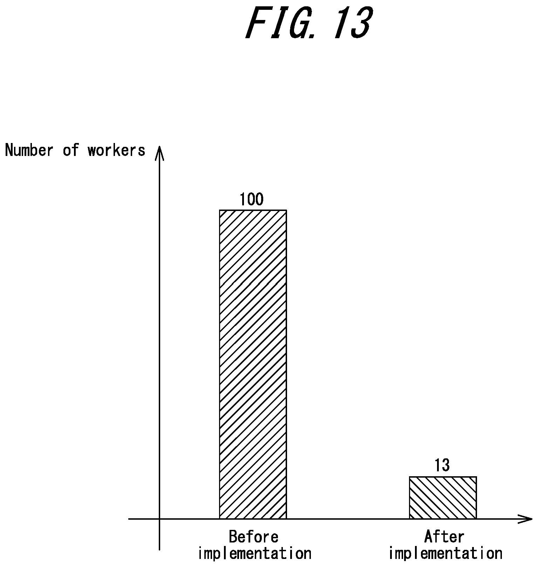

FIG. 13 is a diagram illustrating the effect of reducing the number of workers. Letting the number of workers performing grinding work using the grinder 7 before implementation of the method of the present embodiment be 100, the number of workers after implementation was 13. When the above grinding system, grinding method, and method of producing a steel product, which enable efficient grinding, are provided and work is automated, the number of workers engaged in the grinding work can be reduced (labor saving effect). Furthermore, the automation of work is expected to further improve safety.

While embodiments of the present disclosure have been described with reference to the drawings and examples, it should be noted that various modifications and amendments may easily be implemented by those skilled in the art based on the present disclosure. Accordingly, such modifications and amendments are included within the scope of the present disclosure. For example, functions or the like included in each component, each step (process), or the like can be rearranged without logical inconsistency, and a plurality of components, steps, or the like can be combined into one or divided. Embodiments according to the present disclosure can also be realized as a program executed by a processor included in an apparatus or as a storage medium having the program recorded thereon. Such embodiments are also to be understood as included in the scope of the present disclosure.

REFERENCE SIGNS LIST

1 Material to be ground
2 Grinding target portion
3 Three-dimensional shape measuring device (an example of a shape measuring device)
4 Image processing device (an example of a detection device)

5 Robot motion control unit (an example of a grinding tool control unit)
6 Articulated robot (an example of a grinding device)
7 Grinder
8 Grindstone (example of a grinding tool)
9 Grinding reaction force measuring device
10 Movable cart (an example of a movement mechanism)
11 Turning roller (an example of a movement mechanism)
12 Movement mechanism control unit

**Claims**

1. A grinding system comprising:

   a shape measuring device configured to measure a three-dimensional shape and orientation of a material to be ground;
   a detection device configured to detect a position and shape of a grinding target portion that is present on a surface of the material to be ground;
   a grinding device comprising a grinding tool to grind the grinding target portion;
   a movement mechanism configured to move the material to be ground relative to the shape measuring device and the grinding device;
   a grinding tool control unit configured to generate a trajectory of the grinding tool for grinding the grinding target portion, based on the three-dimensional shape and orientation of the material to be ground measured by the shape measuring device and the position and shape of the grinding target portion detected by the detection device, and control the grinding device so that the grinding tool moves along the trajectory; and
   a movement mechanism control unit configured to control the movement mechanism so that the material to be ground moves relative to the shape measuring device and the grinding device when the shape measuring device measures the material to be ground and when the grinding target portion is ground by the grinding tool.

2. The grinding system according to claim 1, wherein the material to be ground is a circular material having a circular cross-section in an axial direction.

3. The grinding system according to claim 1 or 2, wherein the movement mechanism comprises

   a rotation mechanism configured to rotate the material to be ground in a circumferential direction of the material to be ground relative to the shape measuring device and the grinding device, and
   a slide mechanism configured to move the material to be ground in an axial direction of the material to be ground relative to the shape measuring device and the grinding device.

4. The grinding system according to any one of claims 1 to 3, wherein the movement mechanism control unit relatively moves a circumferential position and an axial position of the material to be ground based on the position and shape of the grinding target portion.

5. The grinding system according to any one of claims 1 to 4,

   wherein in a case in which a size of the grinding target portion is larger than a movable range of the grinding tool, the grinding tool control unit is configured to generate a trajectory within the movable range and control the grinding device so that the grinding tool moves along the trajectory, and
   the movement mechanism control unit is configured to determine relative movement amounts of a circumferential position and an axial position of the material to be ground based on the size of the grinding target portion and the movable range of the grinding tool.

6. The grinding system according to any one of claims 1 to 5, wherein the movement mechanism control unit is configured to determine relative movement amounts of a circumferential position and an axial position of the material to be ground by prioritizing a large-size grinding target portion and excluding other grinding target portions that overlap with the large-size grinding target portion.

7. A grinding method comprising:

a shape measuring process of measuring, by a shape measuring device, a three-dimensional shape and orientation of a material to be ground;

a detecting process of detecting a position and shape of a grinding target portion that is present on a surface of the material to be ground; and

a grinding process of generating a trajectory along which a grinding tool of a grinding device is to move, based on the measured three-dimensional shape and orientation of the material to be ground and the detected position and shape of the grinding target portion, and causing the grinding tool to move along the trajectory and grind the grinding target portion,

wherein in the shape measuring process and the grinding process, the material to be ground is moved relative to the shape measuring device and the grinding device.

8. A method of producing a steel product, the method comprising using the grinding method according to claim 7 to grind a grinding target portion on a surface of a steel product, the steel product being the material to be ground.

FIG. 1

EP 4 768 180 A1

# FIG. 2

# FIG. 3A

Measurement range

Marking
(Position 0)

$\theta$ p1

$\theta$ p0

$\theta$ p2

Marking
(Position 2)

Marking
(Position 1)

## FIG. 3B

```
                    ┌──────────────┐
                    │    Start     │
                    └──────┬───────┘
                           │
        ┌──────────────────▼──────────────────┐
   ┌───►│      Calculate cart position        │── S1
   │    └──────────────────┬──────────────────┘
   │                       │
   │    ┌──────────────────▼──────────────────┐
   │    │       Move cart to cart position k  │── S2
   │    └──────────────────┬──────────────────┘
   │                       │
   │    ┌──────────────────▼──────────────────┐
   │    │      Detect circumferential marking │── S3
   │    └──────────────────┬──────────────────┘
   │  ┌───────────────────►│
   │  │ ┌──────────────────▼──────────────────┐
   │  │ │   Rotate to grinding rotation position i │── S4
   │  │ └──────────────────┬──────────────────┘
   │  │                    │
   │  │ ┌──────────────────▼──────────────────┐
   │  │ │   Grind at grinding rotation position i │── S5
   │  │ └──────────────────┬──────────────────┘
   │  │                    │                       S6
   │  │          ◇─────────▼─────────◇
   │  └─── No ──◇  Grinding performed at          │
   │           ◇ all grinding rotation positions i? │
   │            ◇─────────┬─────────◇
   │                     Yes                        S7
   │            ◇─────────▼─────────◇
   └─── No ────◇ Grinding performed at all cart positions k? ◇
               ◇─────────┬─────────◇
                        Yes
                    ┌────▼─────┐
                    │   End    │
                    └──────────┘
```

# FIG. 4A

EP 4 768 180 A1

# FIG. 4B

# FIG. 4C

# *FIG. 5*

```
┌─────────────────────────────────┐
│         Detection start         │
└─────────────────────────────────┘
                 │
                 ▼
┌─────────────────────────────────┐
│     Specify range for creating a │
│   circumferential development view│
└─────────────────────────────────┘
                 │
                 ▼
┌─────────────────────────────────┐
│ Calculate turning roller rotation time ttr │
└─────────────────────────────────┘
                 │
                 ▼
┌─────────────────────────────────┐
│ Command to start rotation of turning roller │
└─────────────────────────────────┘
                 │
                 ▼
┌─────────────────────────────────┐
│    Command for continuous imaging by │
│  three-dimensional shape measuring device │
└─────────────────────────────────┘
                 │
                 ▼
┌─────────────────────────────────┐
│              Timer              │
└─────────────────────────────────┘
                 │
                 ▼
┌──────────────────────────────────┐      No
│ Create circumferential development view │◄────── Has ttr elapsed since start of imaging?
└──────────────────────────────────┘                        │ Yes
                                                             ▼
┌─────────────────────────────────┐
│ Command to stop rotation of turning roller │
└─────────────────────────────────┘
                 │
                 ▼
┌─────────────────────────────────┐
│        Detect markings in        │
│   circumferential development view │
└─────────────────────────────────┘
                 │
                 ▼
┌─────────────────────────────────┐
│   Determine number of grinding rotation │
│ positions N and grinding rotation angle θpi │
└─────────────────────────────────┘
                 │
                 ▼
┌─────────────────────────────────┐
│        Rotate to grinding        │
│       rotation position i        │
└─────────────────────────────────┘
```

# FIG. 6

## FIG. 7A

Parameters for position (upper) of
material to be ground: coefficients a1, b1

Parameters for position (lower) of
material to be ground: coefficients a2, b2

Parameters for cutout position (upper):
cutout position cU (%)

Parameters for cutout position (lower): cutout range cE (%)

EP 4 768 180 A1

# FIG. 7B

$\theta$b

$\theta$r

$\theta$a

1

Dp

11

pU

Dpp × cU

pL

Dpp × cE

Imaging plane

# FIG. 8A

(xe, ye)

(xs, ys)

x

y

# FIG. 8B

$$\Delta R / (Dp \cdot \pi) = \theta r \, (°)$$

# FIG. 9A

EP 4 768 180 A1

# FIG. 9B

# FIG. 9C

# FIG. 9D

# FIG. 9E

# FIG. 9F

# FIG. 9G

## FIG. 9H

# FIG. 9I

EP 4 768 180 A1

## FIG. 10

```
┌─────────────────────────────────────┐
│   Detect circumferential marking     │
└─────────────────────────────────────┘
                  │
                  ▼
┌─────────────────────────────────────┐
│ Calculate turning roller rotation    │
│ angle $\theta_{ti}$                  │
└─────────────────────────────────────┘
                  │
                  ▼
┌─────────────────────────────────────┐
│    Command to rotate turning roller  │
└─────────────────────────────────────┘
                  │
                  ▼
┌─────────────────────────────────────┐
│    Grind at grinding rotation        │
│    position i                        │
└─────────────────────────────────────┘
```

## FIG. 11

```
┌─────────────────────────────────────┐
│  Rotate to grinding rotation         │
│  position i                          │
└─────────────────────────────────────┘
                  │
                  ▼
┌─────────────────────────────────────┐
│   Issue measurement instruction to   │
│ three-dimensional shape measuring    │
│ device                               │
└─────────────────────────────────────┘
                  │
                  ▼
┌─────────────────────────────────────┐
│      Cut out marking range data      │
└─────────────────────────────────────┘
                  │
                  ▼
┌─────────────────────────────────────┐
│ Extract marking with color           │
│ extraction filter                    │
└─────────────────────────────────────┘
                  │
                  ▼
┌─────────────────────────────────────┐
│ Convert extracted marking to         │
│ individual 3D data                   │
└─────────────────────────────────────┘
                  │
                  ▼
┌─────────────────────────────────────┐
│       Generate trajectory            │
└─────────────────────────────────────┘
```

# FIG. 12

```
┌─────────────────────────────────┐
│     Transmit trajectory data    │
└─────────────────────────────────┘
                 │
                 ▼
┌─────────────────────────────────┐
│          Operate robot          │
└─────────────────────────────────┘
                 │
                 ▼
┌─────────────────────────────────┐
│        Complete grinding        │
└─────────────────────────────────┘
                 │
                 ▼
      No   ╱───────────────────────────────────╲
   ◄───────┤  Is additional processing necessary? │
           ╲───────────────────────────────────╱
                 │ Yes
                 ▼
┌─────────────────────────────────┐
│    Execute additional processing │
└─────────────────────────────────┘
                 │
                 ▼
┌─────────────────────────────────┐
│       Complete grinding at       │
│    grinding rotation position i  │
└─────────────────────────────────┘
```

# FIG. 13

Number of workers

100

13

Before
implementation

After
implementation

## INTERNATIONAL SEARCH REPORT

| International application No. |
|---|
| **PCT/JP2024/032775** |

**A.    CLASSIFICATION OF SUBJECT MATTER**

***B24B 49/12***(2006.01)i; ***B24B 5/18***(2006.01)i; ***H01L 21/304***(2006.01)i
FI:    B24B49/12; B24B5/18 D; H01L21/304 622W; H01L21/304 631

According to International Patent Classification (IPC) or to both national classification and IPC

**B.    FIELDS SEARCHED**

Minimum documentation searched (classification system followed by classification symbols)

B24B49/12; B24B5/18; H01L21/304

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| Y | JP 7248148 B2 (JFE STEEL CORPORATION) 29 March 2023 (2023-03-29) paragraphs [0019], [0023] | 1-4, 7-8 |
| A | | 5-6 |
| Y | JP 5-69317 A (NIPPON STEEL CORPORATION) 23 March 1993 (1993-03-23) paragraphs [0010], [0014], [0015], [0018], [0027], fig. 6-7 | 1-4, 7-8 |
| A | | 5-6 |
| Y | JP 2018-24078 A (JTEKT CORP.) 15 February 2018 (2018-02-15) paragraphs [0010]-[0013] | 3-4 |
| A | | 1-2, 5-8 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **11 October 2024** | **22 October 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 **Japan** | |
| | Telephone No. |

Form PCT/ISA/210 (second sheet) (July 2022)

**INTERNATIONAL SEARCH REPORT**
**Information on patent family members**

International application No.

**PCT/JP2024/032775**

| Patent document cited in search report | | | Publication date (day/month/year) | Patent family member(s) | | | Publication date (day/month/year) |
|---|---|---|---|---|---|---|---|
| JP | 7248148 | B2 | 29 March 2023 | US | 2023/0330802 | A1 | |
| | | | | paragraphs [0038], [0042] | | | |
| | | | | WO | 2022/079974 | A1 | |
| | | | | EP | 4194144 | A1 | |
| | | | | CN | 116323099 | A | |
| | | | | KR | 10-2023-0051579 | A | |
| JP | 5-69317 | A | 23 March 1993 | (Family: none) | | | |
| JP | 2018-24078 | A | 15 February 2018 | WO | 2017/188239 | A1 | |
| | | | | DE | 112017002245 | T5 | |
| | | | | CN | 109070297 | A | |
| | | | | CN | 110064971 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7248148 B